# EUROPEAN PATENT SPECIFICATION

(11) **EP 0 463 511 B1**
(45) Date of publication and mention of the grant of the patent: **24.03.1999**
(21) Application number: 91109796.2
(22) Date of filing: 14.06.1991
(51) Int. Cl.: H01L 29/788, H01L 27/115

(54) **Method of producing a split gate EPROM cell using polysilicon spacers**
Verfahren zum Herstellen einer EPROM-Zelle mit geteiltem Gate und mit Polysilizium-Abstandhaltern
Méthode de fabrication d'une cellule EPROM à grille divisée utilisant des espaceurs en polysilicium

(30) Priority: 28.06.1990 US 545397
(43) Date of publication of application: 02.01.1992
(73) Proprietor: NATIONAL SEMICONDUCTOR CORPORATION, Santa Clara California 95051-8090 (US)
(72) Inventor: Manley, Martin H., San Jose, CA 95125 (US)
(74) Representative: Sparing - Röhl - Henseler Patentanwälte

(56) References cited:
- EP-A- 164 781
- EP-A- 187 278
- EP-A- 335 395
- EP-A- 349 774
- US-A- 4 794 565

## Description

The present invention relates to a method of forming split-gate memory cells of the type used in an erasable programmable read only memory (EPROM). The prior art method has been disclosed by EP-A-0 349 774 and comprises the steps cited in the preamble of claim 1 and claim 2.

Virtual-ground split-gate EPROM cells have been proposed as a means for improving on the packing density and yield of conventional "T" EPROM cells. These cells offer two key features. First, the use of buried N+ bits lines drastically reduces the number of contacts needed in the memory array. This confers an immediate yield advantage, since metal coverage of contact topology is a significant cause of yield loss in scaled integrated circuit technologies. By sharing bit line contacts among a large number of cells, the layout area associated with each cell is further reduced. Second, providing a series select transistor associated with each floating gate insures that the cell cannot be inadvertently turned on due to voltage coupled from the drain to the floating gate. This significantly relieves the constraints on drain programming voltage experienced with a convention T-cell EPROM. Furthermore, associating a series select transistor with each floating-gate confers asymmetry to the operation of the cell. If the source and drain terminals of the cell are interchanged, no programming can take place. This considerably simplifies the programming decoding of the array, since the cell next to the one being programmed is inherently resistent to programming: it cannot be disturbed by the high voltage applied to its source node, which also serves as the drain node of the programmed cell.

U.S. Patent No. 4,639,893 issued January 27, 1987 to Boaz Eitan discloses an implementation of a virtual-ground split-gate EPROM cell. A second split-gate cell implementation has been reported by Ali et al., "A new Staggered Virtual-Ground array architecture implemented in a 4Mb CMOS EPROM", 1989 VLSI Circuits Conference, Tokyo, Japan.

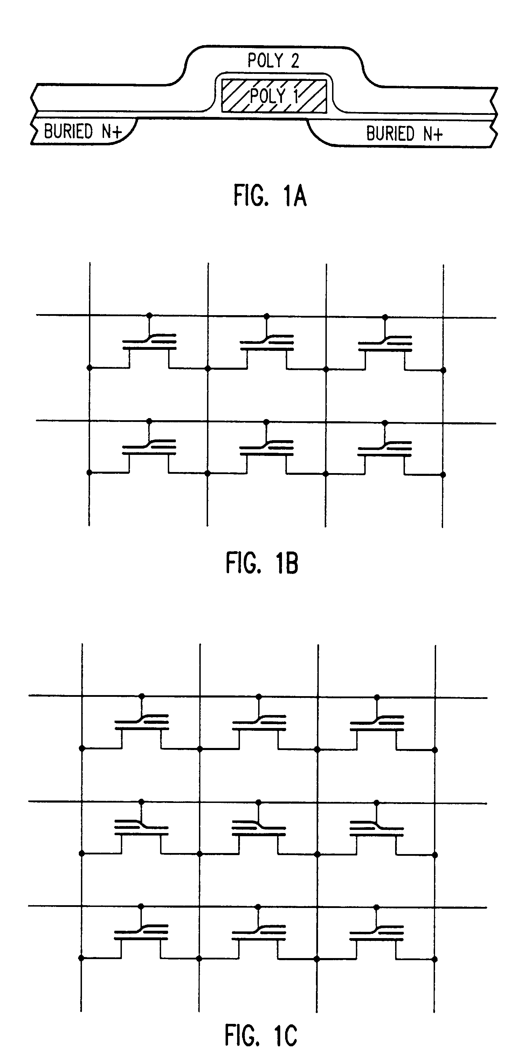

These two implementations of a split-gate cell have the same cross-section, which is shown in Fig 1A. The cells differ only in the way in which they are arrayed. The Eitan array is illustrated in Fig. 1B. The Ali et al array is illustrated in Fig. 1C.

Both of these cells suffer from the same major problem. That is, the length of the series select transistor is defined by the masking of the buried N+ layer. This creates several problems. First, the length of the series select transistor and, hence, the electrical characteristics of the cell, are dependent upon the alignment of the buried N+ region to the polysilicon floating gate. This introduces significant variation in cell performance from die to die and from wafer to wafer. Second, the uncertainty in the final position of the buried N+ region causes variation in the series resistance of the buried bit line, causing further variation in cell performance. Third, in order to insure that the resistance of the buried N+ bit line is acceptably low, under worst-case misalignment of the buried N+ region, the width of the buried N+ bit line must be drawn wider than the required minimum. This increases the overall area of the cell.

The present invention as defined in claim 1 and claim 2 addresses the problems set forth above.

The cell produced in accordance with claim 1 may be similar to that disclosed in EP-A-0 349 774.

A preferred embodiment provides a split-gate EPROM cell that uses a polysilicon spacer to define the gate length of the series select transistor. The length of the polysilicon spacer can be controlled with great precision using existing integrated circuit process technologies and, therefore, can eliminate the misalignment problems associated with the prior art split-gate cells.

To fabricate a split-gate memory cell in accordance with the present invention, a floating gate is formed on a layer of insulating material overlying a semiconductor substrate. A second layer of insulating material is then formed on the floating gate. Opposing sides of the floating gate are then sealed with insulating material. Next, a conductive spacer is formed adjacent to one of the opposing sides of the floating gate. The conductive spacer is insulated from the floating gate by the seal and from the substrate by the first layer of insulating material. Next, the spacer is utilized to define a self-aligned source region while the floating gate is utilized in the self-aligned definition of the drain region. This process results in the floating gate extending only over a portion of the channel region in the manner of a conventional split-gate cell, and with the spacer being positioned over the remaining portion of the channel between the floating gate and the source region. A conductive control gate is then formed in electrical contact with the conductive spacer. The control gate also extends over the floating gate, but is electrically insulated from the floating gate by the second layer of insulating material.

A better understanding of the features and advantages of the present will be obtained by reference to the following detailed description of the invention and accompanying drawings which set forth illustrative embodiments in which the principals of the invention are utilized.

Figure 1A is a cross-sectional view illustrating a conventional virtual-ground split-gate EPROM cell.

Figure 1B is a simple schematic illustration of a virtual-ground EPROM array configuration.

Figure 1C is a simple schematic illustrating a staggered virtual-ground EPROM array configuration.

Figures 2A-2E are cross-sectional views providing progressive illustration of a method of forming a split-gate memory cell in accordance with the present invention.

Figures 3A and 3B are cross-sectional views illustrating alternative steps utilizable in forming a split-gate memory cell in accordance with the present invention.

Figure 4 is plan view of a split-gate memory cell formed in accordance with the present invention in a virtual-ground configuration.

Figure 5 is a plan view of a split-gate memory cell formed in accordance with the present invention in a staggered virtual-ground configuration.

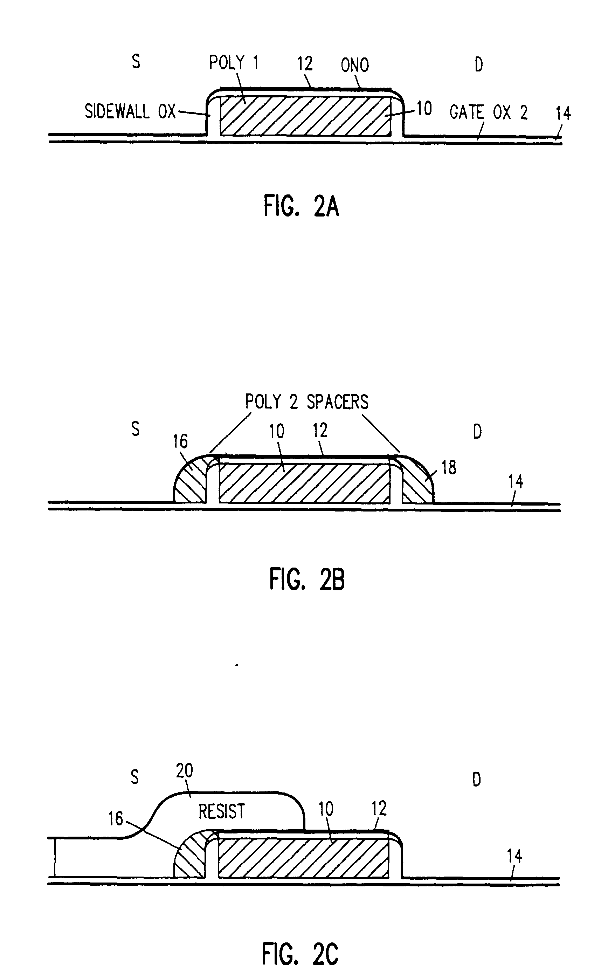

Figs. 2A-2E show a sequence utilizable for fabricating a split-gate memory cell in accordance with the present invention.

In Fig. 2A, a layer of first polysilicon has been deposited on gate oxide and then doped in the conventional manner. Following conventional formation of an oxide-nitride-oxide (ONO) layer 12, the ONO/polysilicon layers are patterned and etched to define a polysilicon floating gate 10. This etching process typically also results in the etching of a portion of the gate oxide layer. A re-oxidation is then been performed to seal the sides of the polysilicon gate 10 with sidewall oxide and to regrow the gate oxide to form gate oxide layer 14.

Next, as shown in Fig. 2B, and in accordance with the present invention, a layer of second polysilicon (approximately 200-300 nm [2000-3000 Angstroms] thick) has been deposited and doped and an anisotropic etch performed to leave well-defined polysilicon spacers 16,18 along the opposing edges of the polysilicon floating gate 10.

As shown in Fig. 2C, the source side S of the structure is then masked with photoresist 20 and the polysilicon spacer 18 on the drain side D is etched away using a selective silicon etch.

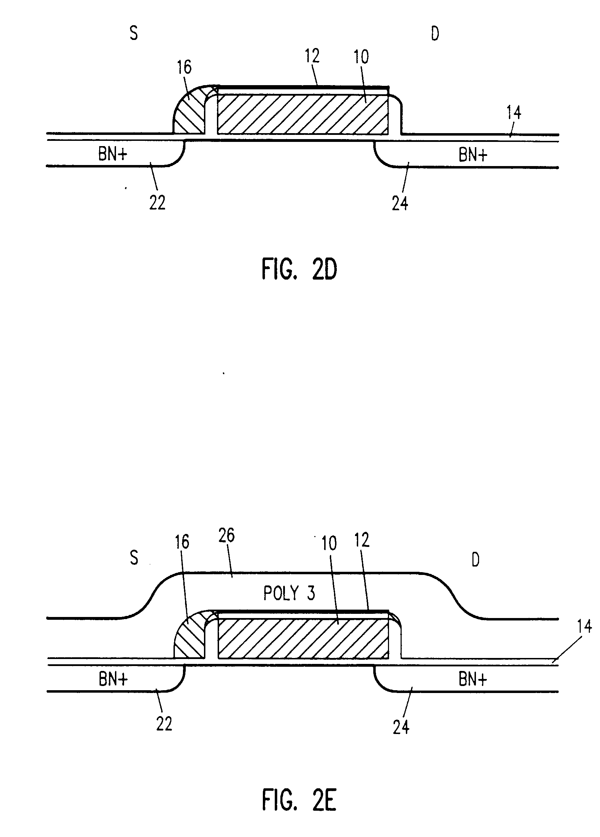

As shown in Fig. 2D, a self-aligned arsenic N+ implant is then performed to form source region 22 and drain region 24. That is, on the source side S, the inner edge of the source region 22 is defined by the outer edge of the polysilicon spacer 16. Similarly, on the drain side D, the inner edge of the drain region 24 is defined by the edge of the polysilicon floating gate 10.

The junction depth of the arsenic implant is chosen such that the buried N+ drain region 24 underlaps the polysilicon floating gate 10 on the drain side D and such that the buried N+ source region 22 underlaps the polysilicon spacer 16 on the source side S, but does not reach all the way across to the polysilicon floating gate 10. In this way, a gated channel region is formed under the polysilicon spacer 16 on the source side S.

As shown in Fig. 2E, a layer of third polysilicon 26 is then deposited and doped. This third polysilicon layer 26 is then masked and etched to form the control gate of the cell. Since the third polysilicon layer 26 is in intimate contact with the polysilicon spacer 16, a direct electrical connection is formed between them. In this way, the final cell structure, shown in Fig. 2E, is electrically equivalent to the conventional virtual-ground EPROM cell shown in Fig. 1A.

The significant advantage of the structure shown in Fig. 2E is that the channel length of the series transistor is defined by the width of the polysilicon spacer 16 and by the lateral diffusion of the buried N+ source region 22, both of which are parameters that can be very tightly controlled. Therefore, the Fig. 2E structure is much more alignment insensitive then are prior art split-gate EPROM cell structures and, thus, can be laid out in smaller areas and show much less variation in electrical performance.

Variances on the basic process and structure described above may be utilized in practicing the present invention, but all retain the central concept of using a polysilicon spacer to define the channel length of the series transistor in a split-gate memory cell.

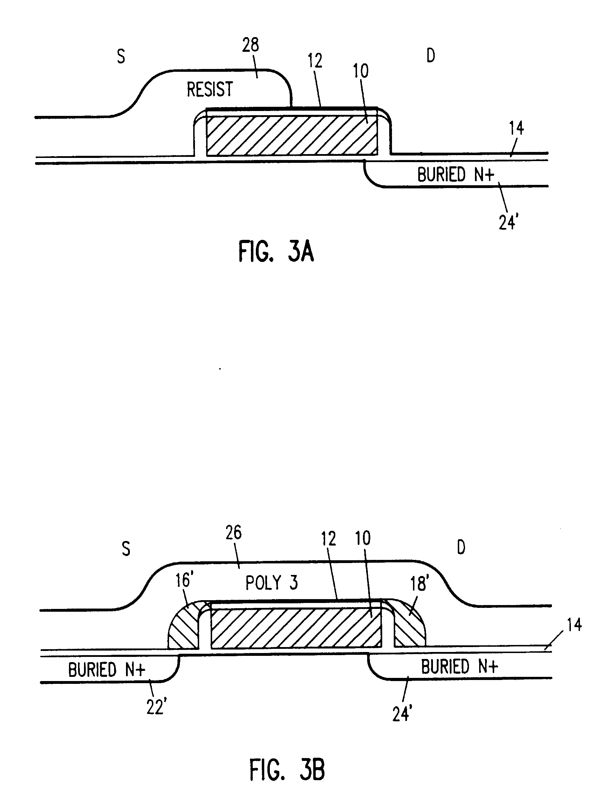

In accordance with an alternative and preferred embodiment of the invention, the need to etch the polysilicon spacer 18 (Fig. 2B) away from the drain side D of the polysilicon floating gate 10 can be eliminated. In this case, processing follows the previous flow to Fig. 2A. Referring to Fig. 3A, at this point, a photoresist masking layer 28 is applied to protect the source side S of the structure and an initial self-aligned N+ implant is performed to form buried N+ drain region 24'. Polysilicon spacers 16' and 18' are then formed as discussed above with respect to Fig. 2B. However, the spacer removal step described with respect to Fig. 2C can now be eliminated, since the early buried N+ implant forms a conducting layer under the polysilicon spacer 18' on the drain side D. Processing then continues as previously described, arriving at the final structure shown in Fig. 3B.

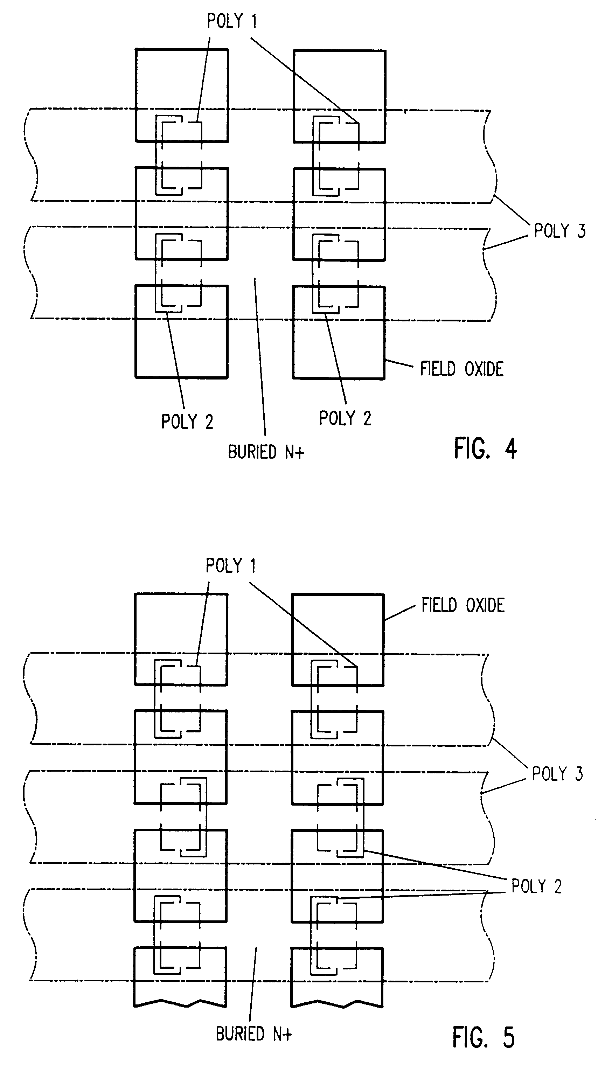

In the foregoing description of the invention, only the cell cross-section has been discussed. Fig. 4 shows a plan view of the cell, laid out to correspond topologically with the prior art array shown in Fig. 1B. A plan view of the cell with a staggered layout corresponding to that shown in prior art Fig. 1C is shown in Fig. 5.

It should be understood that various alternatives to the embodiments of the invention described herein may be employed in practicing the invention. It is intended that the following claims define the scope of the invention and that methods within the scope of these claims and their equivalents be covered thereby.

## Claims

1. A method of forming a split-gate memory cell in a semiconductor substrate of a first conductivity type, the method comDrising the steps of:
(a) forming a conductive floating gate (10) overlying the substrate but electrically insulated therefrom by a layer (14) of first dielectric material, the floating gate having a layer of second dielectric material (12) formed thereon,
(b) forming a sidewall insulator on a first edge of the floating gate,
(c) forming a conductive spacer (16) adjacent to the first edge of the floating gate but insulated therefrom by the sidewall insulator,
(d) forming first and second regions (22, 24) of a second conductivity type in the substrate using a second edge of the floating gate to define an edge of the first region, and using an edge of the conductive spacer to define an edge of the second region,
(e) forming a conductive control gate (26) in electrical contact with the conductive spacer and overlying but electrically insulated from the floating gate by the layer of second dielectric material,
characterized in that said control gate is formed subsequent to said conductive spacer.

2. A method of forming a split-gate memory cell in a semiconductor substrate of a first conductivity type, the method comprising the steps of:
(a) forming a conductive floating gate (10) overlying the substrate but electrically insulated therefrom by a layer (14) of first dielectric material, the floating gate having a layer of second dielectric material (12) formed thereon;
(b) forming a first region (24') of a second conductivity type in the substrate using a first edge of the floating gate to define an edge of the first region;
(c) forming first and second sidewall insulators on the first edge and a second opposing edge, respectively, of the floating gate;
(d) forming first and second conductive spacers (16',18') adjacent to the first and second edges, respectively, of the floating gate but insulated therefrom by the respective first and second sidewall insulators;
(e) forming a second region (22') of the second conductivity type in the substrate using an edge of the second conductive spacer to define an edge of the second region; and
(f) forming a conductive control gate (26) in electrical contact with the first and second conductive spacers and overlying but electrically insulated from the floating gate by the layer of second dielectric material
characterised in that said control gate is formed subsequent to said conductive spacers.

## Patentansprüche

1. Verfahren zum Bilden einer Speicherzelle mit geteiltem Gate in einem Halbleitersubstrat eines ersten Leitfähigkeitstyps, wobei das Verfahren die folgenden Schritte enthält:
(a) Bilden eines leitenden schwebenden Gates (10), das über dem Substrat liegt, jedoch hiervon durch eine Schicht (14) eines ersten dielektrischen Materials elektrisch isoliert ist, wobei auf dem schwebenden Gate eine Schicht eines zweiten dielektrischen Materials (12) gebildet ist,
(b) Bilden eines Seitenwandisolators an einer ersten Kante des schwebenden Gates,
(c) Bilden eines leitenden Abstandshalters (16), der an die erste Kante des schwebenden Gates angrenzt, jedoch hiervon durch den Seitenwandisolator isoliert ist,
(d) Bilden eines ersten und eines zweiten Bereichs (22, 24) eines zweiten Leitfähigkeitstyps im Substrat, wobei eine zweite Kante des schwebenden Gates verwendet wird, um eine Kante des ersten Bereichs zu definieren, und wobei eine Kante des leitenden Abstandshalters verwendet wird, um eine Kante des zweiten Bereichs zu definieren,
(e) Bilden eines leitenden Steuergates (26) in elektrischem Kontakt mit dem leitenden Abstandshalter, der über dem schwebenden Gate liegt, jedoch hiervon durch die Schicht des zweiten dielektrischen Materials elektrisch isoliert ist,
dadurch gekennzeichnet, daß das Steuergate nach dem leitenden Abstandshalter gebildet wird.

2. Verfahren zum Bilden einer Speicherzelle mit geteiltem Gate in einem Halbleitersubstrat eines ersten Leitfähigkeitstyps, wobei das Verfahren die folgenden Schritte enthält:
(a) Bilden eines leitenden schwebenden Gates (10), das über dem Substrat liegt, jedoch hiervon durch eine Schicht (14) eines ersten dielektrischen Materials elektrisch isoliert ist, wobei auf dem schwebenden Gate eine Schicht eines zweiten dielektrischen Materials (12) gebildet ist;
(b) Bilden eines ersten Bereichs (24') eines zweiten Leitfähigkeitstyps im Substrat, wobei eine erste Kante des schwebenden Gates verwendet wird, um eine Kante des ersten Bereichs zu definieren;
(c) Bilden eines ersten und eines zweiten Seitenwandisolators an der ersten Kante bzw. an einer zweiten gegenüberliegenden Kante des schwebenden Gates;
(d) Bilden eines ersten und eines zweiten leitenden Abstandshalters (16', 18') angrenzend an die erste bzw. die zweite Kante des schwebenden Gates, die jedoch hiervon durch den ersten bzw. den zweiten Seitenwandisolator isoliert sind;
(e) Bilden eines zweiten Bereichs (22') des zweiten Leitfähigkeitstyps im Substrat, wobei eine Kante des zweiten leitenden Abstandshalters verwendet wird, um eine Kante des zweiten Bereichs zu definieren; und
(f) Bilden eines leitenden Steuergates (26) in elektrischem Kontakt mit dem ersten und mit dem zweiten leitenden Abstandshalter, wobei das leitende Steuergate über dem schwebenden Gate liegt, jedoch hiervon durch die Schicht des zweiten dielektrischen Materials elektrisch isoliert ist,
dadurch gekennzeichnet, daß das Steuergate nach den leitenden Abstandshaltern gebildet wird.

## Revendications

1. Procédé pour former une cellule de mémoire à grille divisée dans un substrat semiconducteur d'un premier type de conductivité, le procédé comprenant les étapes de :
(a) former une grille flottante conductrice (10) recouvrant le substrat, mais isolée électriquement de celui-ci par une couche (14) d'un premier matériau diélectrique, la grille flottante comportant une couche d'un second matériau diélectrique (12) formée sur elle,
(b) former un isolateur de paroi latérale sur un premier bord de la grille flottante,
(c) former un espaceur conducteur (16) adjacent au premier bord de la grille flottante, mais isolé de celle-ci par l'isolateur de paroi latérale,
(d) former des première et seconde régions (22, 24) d'un second type de conductivité dans le substrat en utilisant un second bord de la grille flottante pour définir un bord de la première région, et en utilisant un bord de l'espaceur conducteur pour définir un bord de la seconde région,
(e) former une grille de commande conductrice (26) en contact électrique avec l'espaceur conducteur et recouvrant la grille flottante, mais isolée électriquement de celle-ci par la couche de second matériau diélectrique,
caractérisé en ce que ladite grille de commande est formée après ledit espaceur conducteur.

2. Procédé pour former une cellule de mémoire à grille divisée dans un substrat semiconducteur d'un premier type de conductivité, le procédé comprenant les étapes de :
(a) former une grille flottante conductrice (10) recouvrant le substrat, mais isolée électriquement de celui-ci par une couche (14) d'un premier matériau diélectrique, la grille flottante comportant une couche d'un second matériau diélectrique (12) formée sur elle;
(b) former une première région (24') d'un second type de conductivité dans le substrat en utilisant un premier bord de la grille flottante pour définir un bord de la première région;
(c) former des premier et second isolateurs de paroi latérale respectivement sur le premier bord et un second bord opposé de la grille flottante;
(d) former des premier et second espaceurs conducteurs (16', 18') adjacents respectivement aux premier et second bords de la grille flottante, mais isolés de celle-ci respectivement par les premier et second isolateurs de paroi latérale;
(e) former une seconde région (22') du second type de conductivité dans le substrat en utilisant un bord du second espaceur conducteur pour définir un bord de la seconde région; et
(f) former une grille de commande conductrice (26) en contact électrique avec les premier et second espaceurs conducteurs et recouvrant la grille flottante, mais isolée électriquement de celle-ci par la couche de second matériau diélectrique;
caractérisé en ce que ladite grille de commande est formée après lesdits espaceurs conducteurs.
